# EUROPÄISCHE PATENTSCHRIFT

(11) **EP 4 386 413 B1**
(45) Veröffentlichungstag und Bekanntmachung des Hinweises auf die Patenterteilung: **20.05.2026**
(21) Anmeldenummer: 22213892.7
(22) Anmeldetag: 15.12.2022
(51) Int. Cl.: G01R 33/385

(54) **GRADIENTENSPULENEINHEIT MIT KÜHLKANAL**
GRADIENT COIL UNIT WITH COOLING CHANNEL
UNITÉ DE BOBINES À GRADIENT AVEC CANAL DE REFROIDISSEMENT

(43) Veröffentlichungstag der Anmeldung: 19.06.2024
(73) Patentinhaber: Siemens Healthineers AG, 91301 Forchheim (DE)
(72) Erfinder: Dietz, Peter, 90762 Fürth (DE); Stocker, Stefan, 91091 Großenseebach (DE)
(74) Vertreter: Siemens Healthineers Patent Attorneys

(56) Entgegenhaltungen:
- EP-A1- 3 608 929
- CN-U- 212 275 949
- DE-A1- 19 839 987

## Beschreibung

Die Erfindung betrifft eine Gradientenspuleneinheit umfassend eine Primärlage mit zwei primären Leiterstruktureinheiten jeweils seriell umschließend einen Kühlkanal, ein Gradientensystem und ein Magnetresonanzgerät.

In einem Magnetresonanzgerät wird üblicherweise der zu untersuchende Körper eines Untersuchungsobjektes, insbesondere eines Patienten, mit Hilfe eines Hauptmagneten einem relativ hohen Hauptmagnetfeld, beispielsweise von 1,5 oder 3 Tesla, ausgesetzt. Im Rahmen einer Magnetresonanzbildgebung (MR-Bildgebung) werden mit Hilfe einer Gradientenspuleneinheit Gradientenpulse ausgespielt. Zusätzlich werden über eine Hochfrequenzantenneneinheit dann mittels geeigneter Antenneneinrichtungen hochfrequente Hochfrequenz-Pulse (HF-Pulse), insbesondere Anregungspulse, ausgesendet, was dazu führt, dass die Kernspins bestimmter, durch diese HF-Pulse resonant angeregter Atome um einen definierten Flipwinkel gegenüber den Magnetfeldlinien des Hauptmagnetfelds verkippt werden. Bei der Relaxation der Kernspins werden Hochfrequenz-Signale, so genannte Magnetresonanz-Signale, abgestrahlt, die mittels geeigneter Hochfrequenzantennen empfangen und dann weiterverarbeitet werden. Aus den so akquirierten Rohdaten können schließlich die gewünschten Bilddaten rekonstruiert werden.

Für eine bestimmte Messung ist daher eine bestimmte Magnetresonanz-Steuerungssequenz (MR-Steuerungssequenz), auch Pulssequenz genannt, auszusenden, welche aus einer Folge von Hochfrequenz-Pulsen, beispielsweise Anregungspulsen und Refokussierungspulsen, sowie passend dazu koordiniert auszusendenden Gradientenpulsen in verschiedenen Gradientenachsen entlang verschiedener Raumrichtungen besteht. Zeitlich passend hierzu werden Auslesefenster gesetzt, welche die Zeiträume vorgeben, in denen die induzierten Magnetresonanz-Signale erfasst werden.

Eine Gradientenspuleneinheit umfasst herkömmlich drei Gradientenspulen. Die drei Gradientenspulen sind dazu ausgebildet, Magnetfeldgradienten in drei zueinander senkrechte Raumrichtungen zu erzeugen. Ein Magnetfeldgradient ist typischerweise ein Magnetfeld erster Ordnung und/oder linearer Ordnung, insbesondere ein Magnetfeld, dessen Amplitude entlang einer Raumrichtung linear ansteigt. Eine Gradientenspule umfasst herkömmlich zumindest eine Primärspule und eine Sekundärspule, wobei beide hohlzylinderförmig ausgestaltet sind. Außerhalb des Patientenaufnahmebereiches wird die Wirkung einer Primärspule durch eine der Primärspule zugeordnete Sekundärspule weitgehend unterdrückt. Die Sekundärspule umgibt typischerweise die entsprechende Primärspule und ist mit dieser elektrisch in Serie geschaltet.

Ein Magnetfeldgradient wird erzeugt durch Ansteuerung der Primärspule mit elektrischen Strömen, deren Amplituden mehrere 100 A erreichen und die häufigen und raschen Wechseln der Stromrichtung mit Anstiegs- und Abfallraten von mehreren 100 kA/s unterliegen. Ein Magnetfeldgradient ist somit ein zeitlich veränderliches Magnetfeld.

Stärkere Magnetfeldgradienten und/oder Anstiegs- und Abfallraten ermöglichen typischerweise eine schnellere Aufnahme von Rohdaten und/oder eine höhere Auflösung von Bilddaten. Insbesondere bei Untersuchungen des Kopfes eines Untersuchungsobjektes, besonders bei diffusionsgewichteten Aufnahmen und/oder bei einer Verwendung eines Magnetresonanzgerätes mit einem Hauptmagnetfeld von mehr als 3 Tesla, sind besonders starke Magnetfeldgradienten von bis zu 500 mT/m mit Anstiegs- und Abfallraten von bis zu 1000 T/s/m, in besonderen Fällen bis 2000 T/s/m, wünschenswert. Hierbei entsteht Verlustleistung in Form von Wärme, welche besonders effizient abgeführt werden muss, um einen kontinuierlichen Betrieb der Gradientenspuleneinheit sicherzustellen.

Insbesondere für Kopfuntersuchung sind Gradientenspuleneinheiten bekannt, welche bei Bedarf innerhalb des Patientenaufnahmebereiches positionierbar sind. Beispiele hierfür sind in US10908241 und US11422215 offenbart. Weitere Gradientenspuleneinheiten sind beispielsweise aus CN212275949U, EP3608929A1 und DE19839987A1 bekannt.

Der Erfindung liegt die Aufgabe zugrunde, eine Gradientenspuleneinheit zur Erzeugung eines besonders hohen Magnetfeldgradienten mit starken Anstiegs- und Abfallraten anzugeben. Die Aufgabe wird durch die Merkmale der unabhängigen Ansprüche gelöst. Vorteilhafte Ausgestaltungen sind in den Unteransprüchen beschrieben.

Erfindungsgemäß wird eine Gradientenspuleneinheit nach Anspruch 1 bereitgestellt.

Die erfindungsgemäße Gradientenspuleneinheit umfasst eine Gradientenspule umgebend eine Zylinderachse und ausgebildet zur Erzeugung eines Magnetfeldgradienten in eine erste Raumrichtung, welche Gradientenspule eine hohlzylindrische Primärlage umfassend zwei primäre Leiterstruktureinheiten und einen Kühlkanal umfasst,
wobei jeweils eine primäre Leiterstruktureinheit der zwei primären Leiterstruktureinheiten aus jeweils einem primären elektrischen Leiter gebildet wird, welcher primäre elektrische Leiter aus zwei seriell miteinander verbundenen Abschnitten besteht, wobei sich die Länge der beiden Abschnitte um weniger als 5% unterscheidet, wobei der primäre elektrische Leiter derart spiralförmig in Windungen angeordnet ist, dass
- zwei benachbarte Windungen des primären elektrischen Leiters den beiden voneinander verschiedenen Abschnitten zuzuordnen sind, wobei eine Windung einem jeweiligen Abschnitt zuzuordnen ist, wenn die Windung aus dem jeweiligen Abschnitt des primären elektrischen Leiters geformt wird,
- der Kühlkanal zumindest teilweise zwischen den beiden Abschnitten angeordnet ist,
- die beiden Abschnitte und der Kühlkanal zumindest teilweise parallel verlaufen, und
- die beiden Abschnitte jeweils eine Berührungsfläche mit dem Kühlkanal aufweisen.

Die erste Raumrichtung ist vorzugsweise senkrecht zur Längsrichtung und entspricht der x-Richtung oder der y-Richtung. Die Gradientenspuleneinheit ist hohlzylinderförmig umgebend die Zylinderachse in Längsrichtung ausgebildet. Die Zylinderachse entspricht typischerweise der Längsrichtung und/oder ist parallel zu dieser. Die Primärlage kann der Primärspule der Gradientenspule entsprechen. Die Primärspule der Gradientenspule kann weitere Lagen, insbesondere weitere Primärlagen umfassen. Die Primärlage beschreibt eine Mantelfläche eines Zylinders. Eine primäre Leiterstruktureinheit ist auf der von der Primärlage beschriebenen Mantelfläche angeordnet und/oder sattelförmig ausgestaltet. Die zwei primären Leiterstruktureinheiten sind vorzugsweise auf der gleichen Mantelfläche eines Zylinders angeordnet und/oder sind sattelförmig mit gleicher Krümmung ausgestaltet und/oder weisen den gleichen radialen Abstand zur Zylinderachse auf. Die zwei primären Leiterstruktureinheiten unterscheiden sich vorzugsweise durch deren Position in Umfangsrichtung des Zylinders, welche sich beispielsweise um 180° unterscheiden kann, oder in Längsrichtung, wobei eine primäre Leiterstruktureinheit eine Hälfte des Zylinders in Längsrichtung in Umfangsrichtung vollständig umschließt.

Die Primärlage umfasst zwei primäre elektrische Leiter. Jeder primäre elektrische Leiter der zwei primären elektrischen Leiter ist jeweils zu einer primären Leiterstruktureinheit der zwei primären Leiterstruktureinheiten der Primärlage geformt. Eine primäre Leiterstruktureinheit umfasst einen primären elektrischen Leiter in einer definierten geometrischen Anordnung. Der primäre elektrische Leiter und/oder die primäre Leiterstruktureinheit ist zumindest teilweise spiralförmig, aufweisend Windungen mit unterschiedlichem Radius relativ zu zumindest einem Fixpunkt, geformt.

Jeder primäre elektrische Leiter der zwei primären elektrischen Leiter ist in zwei elektrisch seriell miteinander verbundene Abschnitte unterteilbar. Der primäre elektrische Leiter ist derart spiralförmig in Windungen angeordnet, dass zwei benachbarte Windungen des elektrischen Leiters den beiden voneinander verschiedenen Abschnitten zuzuordnen sind. Der primäre elektrische Leiter besteht aus den zwei elektrisch seriell miteinander verbundenen Abschnitten.

Die beiden Abschnitte gehen vorzugsweise an genau einer Position kontinuierlich ineinander über, sind demnach insbesondere an dieser Position zusammenhängend. Die Länge der beiden Abschnitte unterscheidet sich um weniger als 5%. Die beiden Abschnitte können demnach als Hälften des primären elektrischen Leiters bezeichnet werden.

Bei zumindest teilweise spiralförmiger Ausformung des primären elektrischen Leiters und/oder der primären Leiterstruktureinheit aufweisend Windungen mit unterschiedlichem Radius relativ zu zumindest einem Fixpunkt, ist der primäre elektrische Leiter derart angeordnet, dass auf einer Verbindungslinie zwischen dem Fixpunkt und einem äußeren Rand der Leiterstruktureinheit mehrere Windungen verlaufen, wobei die Verbindungslinie zumindest teilweise abwechselnd eine einem ersten Abschnitt der zwei seriell miteinander verbundenen Abschnitte zugeordnete Windung und eine dem zweiten Abschnitt der zwei seriell miteinander verbundenen Abschnitte zugeordnete Windung kreuzt. Eine Windung ist dem ersten Abschnitt zuzuordnen, wenn die Windung aus dem ersten Abschnitt des elektrischen Leiters geformt wird. Eine Windung ist dem zweiten Abschnitt zuzuordnen, wenn die Windung aus dem zweiten Abschnitt des elektrischen Leiters geformt wird.

Die Primärlage umfasst zumindest einen Kühlkanal, bevorzugt zumindest zwei Kühlkanäle. Ein Kühlkanal ist typischerweise hohlzylindrisch ausgebildet und zur Aufnahme eines Kühlmediums, insbesondere eines Fluids, ausgebildet. Der Kühlkanal ist typischerweise derart ausgebildet, dass von diesem ein Fluid umschlossen werden kann, oder innerhalb des Kühlkanals ein Kühlmedium, insbesondere ein Fluid, strömen kann, insbesondere entlang der Länge des Kühlkanals. Der Kühlkanal ist vorzugsweise von einem Kühlmedium durchströmbar.

Der erste Abschnitt, der zweite Abschnitt und der Kühlkanal sind zumindest teilweise parallel angeordnet. Die zueinander überwiegend parallele Anordnung kann als eine Einheit bezeichnet werden. Die Einheit ist zumindest teilweise spiralförmig in Windungen umgebend den Fixpunkt angeordnet. Zwischen dem ersten Abschnitt und dem zweiten Abschnitt einer Einheit ist der Kühlkanal angeordnet, wobei die Form des primären elektrischen Leiters, insbesondere des ersten Abschnittes und des zweiten Abschnittes, und die Form des Kühlkanals derart aufeinander abgestimmt sind, dass der erste Abschnitt mit dem Kühlkanal und der zweite Abschnitt mit dem Kühlkanal jeweils eine Berührungsfläche aufweisen. Die Berührungsflächen sind vorzugsweise zumindest teilweise parallel zur parallelen Anordnung und/oder entlang der parallelen Anordnung der beiden Abschnitte und des Kühlkanals. Die beiden Abschnitte verlaufen vorzugsweise parallel zur Längsachse des Kühlkanals. Insbesondere kann der Kühlkanal entlang zumindest 70%, bevorzugt entlang zumindest 80%, besonders bevorzugt entlang zumindest 90% seiner Länge vom ersten Abschnitt und zweiten Abschnitt zumindest teilweise in seiner Umfangsrichtung umschlossen sein.

Bei der erfindungsgemäßen zumindest teilweise spiralförmigen Ausformung des primären elektrischen Leiters und/oder der primären Leiterstruktureinheit und des Kühlkanals und/oder der Einheit aufweisend Windungen mit unterschiedlichem Radius relativ zu zumindest einem Fixpunkt, ist die Einheit derart angeordnet, dass auf einer Verbindungslinie zwischen dem Fixpunkt und einem äußeren Rand der Leiterstruktureinheit die Einheit in mehreren Windungen verläuft, wobei die Verbindungslinie mehrfach die Einheit in der Reihenfolge erster Abschnitt, Kühlkanal, zweiter Abschnitt kreuzt.

Die erfindungsgemäße Gradientenspuleneinheit ermöglicht demnach eine Formung eines Hohlleiters aus zwei elektrisch seriell miteinander verbundenen Abschnitten des gleichen primären elektrischen Leiters und einem dazwischen gelagerten Kühlkanal. Diese Anordnung des Kühlkanals ermöglicht eine besonders effiziente Kühlung und die erfindungsgemäße geometrische Anordnung und elektrische Verschaltung des primären elektrischen Leiters ermöglicht eine besonders hohe Stromdichte in der Primärlage: Hierdurch können insbesondere maximale Gradientenamplituden von bis zu 500 mT/m/s erzielt werden.

Eine Ausführungsform der Gradientenspuleneinheit sieht vor, dass der primäre elektrische Leiter derart angeordnet ist, dass bei Ansteuerung der Gradientenspule in beiden Abschnitten ein paralleler, insbesondere gleichgerichteter, Stromfluss erzeugt wird. Der primäre elektrische Leiter, insbesondere die beiden Abschnitte, sind vorzugsweise derart angeordnet, dass bei Ansteuerung der Primärspule und/oder der Primärlage, insbesondere bei Ansteuerung der primären Leiterstruktureinheit, ein elektrischer Strom in beiden Abschnitten gleich und/oder parallel ausgerichtet ist. Der Stromfluss beiderseits des Kühlkanals im ersten Abschnitt und zweiten Abschnitt ist demnach gleichgerichtet. Diese Ausführungsform ermöglicht eine besonders hohe Stromdichte, wodurch eine besonders hohe maximale Amplitude des Magnetfeldgradienten in die erste Raumrichtung erzielt werden kann.

Eine Ausführungsform der Gradientenspuleneinheit sieht vor, dass der Kühlkanal elektrisch leitfähiges Material umfasst und der Kühlkanal auf der dem primären elektrischen Leiter und/oder den beiden Abschnitten zugewandten Seite eine isolierende Beschichtung aufweist.

Der primäre elektrische Leiter umfasst vorzugsweise elektrisch leitfähiges Material, insbesondere ein Metall, bevorzugt Kupfer und/oder Aluminium und/oder ist aus Kupfer und/oder Aluminium gebildet. Demnach umfassen die beiden Abschnitte vorzugsweise elektrisch leitfähiges Material, insbesondere ein Metall, bevorzugt Kupfer und/oder Aluminium. Der Kühlkanal umfasst vorzugsweise ein Metall, insbesondere Stahl, und/oder ist aus Metall und/oder Stahl gefertigt.

Der Kühlkanal ist typischerweise hohlzylinderförmig ausgestaltet. Der Kühlkanal weist gemäß dieser Ausführungsform beispielsweise eine isolierende Beschichtung auf der dem Kühlmedium abgewandten Seite, insbesondere auf der äußeren Mantelfläche, auf. Der Kühlkanal kann auch auf der dem Kühlmedium zugewandten Seite, insbesondere auf der inneren Mantelfläche, eine isolierende Beschichtung aufweisen. Eine isolierende Beschichtung ist typischerweise eine hochohmige Schicht, insbesondere ein Lack, die einen höheren elektrischen Widerstand aufweist als der Kühlkanal und/oder der primäre elektrische Leiter.

Insbesondere bei einer derartigen Anordnung des primären elektrischen Leiters, dass bei Ansteuerung der Gradientenspule in beiden Abschnitten ein paralleler, insbesondere gleichgerichteter, Stromfluss erzeugt wird, liegt im ersten Abschnitt und im zweiten Abschnitt beidseitig des Kühlkanals eine voneinander unterschiedliche Spannung an. Bei Ansteuerung einer einzelnen primären Leiterstruktureinheit kann beispielsweise eine Spannung von 550V abfallen, sodass bei Unterteilung des primären elektrischen Leiters in zwei Abschnitte pro Abschnitt eine Spannung von etwa 275V abfällt. Dies kann zu einer Spannungsdifferenz von 275V zwischen dem ersten Abschnitt und dem zweiten Abschnitt beiderseits des Kühlkanals, insbesondere an gleicher Längsposition relativ zum Kühlkanal, führen. Die isolierende Beschichtung verhindert einen Stromfluss vom ersten Abschnitt zum zweiten Abschnitt über den Kühlkanal und/oder einen Stromfluss entlang des Kühlkanals oder eines vom Kühlkanal umfassten Kühlmediums, insbesondere ein Überbrücken und/oder Kurzschließen des Kühlkanals, insbesondere an einer Längsposition, welche nicht der Position entspricht, an welcher Position die beiden Abschnitte seriell kontinuierlich ineinander übergehen. Dadurch kann die Erzeugung des Magnetfeldgradienten in die erste Raumrichtung sichergestellt werden. Der primäre elektrische Leiter weist typischerweise eine isolierende Beschichtung auf und/oder ist mit Vergussmaterial, insbesondere Epoxidharz, vergossen. Eine derartige isolierende Beschichtung des primären elektrischen Leiters kann jedoch Isolationsfehlstellen aufweisen, wodurch der elektrische Widerstand zwischen den beiden Abschnitten reduziert werden kann und bei fehlender Isolierung des Kühlkanals in Längsrichtung weiter auseinanderliegende Isolationsfehlstellen an der isolierenden Beschichtung des primären elektrischen Leiters ein Stromfluss vom ersten Abschnitt zum zweiten Abschnitt erfolgen kann.

Diese Ausführungsform ermöglicht, dass eine primäre Leiterstruktureinheit mit einer erfindungsgemäßen Anordnung auch bei großen Spannungsunterschieden zwischen dem ersten Abschnitt und dem zweiten Abschnitt, also insbesondere bei hohem Abfall der Spannung über die gesamte primäre Leiterstruktureinheit hinweg, robust betrieben werden kann.

Eine Ausführungsform der Gradientenspuleneinheit sieht vor, dass die beiden Abschnitte senkrecht zu einer Längsachse des Kühlkanals durch den Kühlkanal und/oder durch eine isolierende Schicht voneinander getrennt sind. Die isolierende Schicht kann beispielsweise eine Vergussmasse der Gradientenspuleneinheit, insbesondere Epoxidharz, umfassen. Die isolierende Schicht kann auch einen Lack und/oder eine Folie umfassen. Die isolierende Schicht kann auch als eine isolierende Beschichtung der Oberfläche des primären elektrischen Leiters ausgebildet sein.

Vorzugsweise weist der primäre elektrische Leiter und/oder die beiden Abschnitte eine isolierende Beschichtung auf. Diese Ausführungsform ermöglicht einen definierten Stromfluss im primären elektrischen Leiter und verhindert insbesondere einen Stromfluss über den Kühlkanal und/oder ein Brücken der beiden Abschnitte durch den Kühlkanal. Insbesondere in Kombination mit einer isolierenden Beschichtung des Kühlkanals kann sichergestellt werden, dass selbst bei Isolationsfehlstellen in einer isolierenden Beschichtung und/oder bei hohen Spannungsdifferenzen zwischen dem ersten Abschnitt und dem zweiten Abschnitt, ein robuster Betrieb der Primärlage gewährleistet werden kann.

Eine Ausführungsform der Gradientenspuleneinheit sieht vor, dass die beiden Abschnitte den Kühlkanal zumindest teilweise umschließen und/oder zumindest teilweise bündig am Kühlkanal anliegen. Insbesondere kann die Form des primären elektrischen Leiters und/oder der beiden Abschnitte an einen Querschnitt des Kühlkanals angepasst sein. Diese Ausführungsform vergrößert die Berührungsfläche zwischen dem primären elektrischen Leiter und dem Kühlkanal, wodurch die Kühlung besonders effizient wirken kann.

Eine Ausführungsform der Gradientenspuleneinheit sieht vor, dass der Kühlkanal hohlzylinderförmig ausgestaltet ist und/oder der primäre elektrische Leiter einen Querschnitt in Form eines Rechteckes mit einer Aussparung in Form eines Kreissegmentes aufweist. Insbesondere können beide Abschnitte einen Querschnitt in Form eines Rechteckes mit einer Aussparung in Form eines Kreissegmentes aufweist. Gemäß dieser Ausführungsform weist die Einheit umfassend den ersten Abschnitt, den zweiten Abschnitt und den Kühlkanal einen rechteckigen Querschnitt auf, wobei der Kühlkanal einen runden Querschnitt aufweist. Rechteckige Querschnitte sind insbesondere bei der Fertigung einer Gradientenspuleneinheit vorteilhaft, da eine derartige primäre Leiterstruktureinheit besonders robust sattelförmig ausgestaltet werden kann und zugleich eine hohe Stromdichte ermöglicht. Ein runder Querschnitt des Kühlkanals ermöglicht zugleich eine besonders effiziente Kühlung des primären elektrischen Leiters.

Eine Ausführungsform der Gradientenspuleneinheit sieht vor, dass die zwei primären Leiterstruktureinheiten zueinander achsensymmetrisch, insbesondere mit der Zylinderachse als Symmetrieachse, ausgebildet sind.

Die Gradientenspuleneinheit und/oder die Primärlage ist typischerweise in zwei Hälften unterteilbar und/oder die Gradientenspuleneinheit umfasst zwei Hälften, wobei diese zwei Hälften typischerweise lediglich zwei disjunkte geometrische Bereiche der Gradientenspuleneinheit definieren. Die zwei Hälften bezeichnen typischerweise Bereiche der Gradientenspuleneinheit, wobei ein Übergang zwischen den zwei Hälften jeweils frei von einer physischen und/oder sichtbaren Trennung ist. Die Hälften der Gradientenspuleneinheit sind typischerweise durch eine Ebene parallel zur Längsrichtung, insbesondere durch eine Ebene umfassend die Zylinderachse, oder durch eine Ebene senkrecht zur Längsrichtung, voneinander getrennt. Die Primärlage umfasst zwei primäre Leiterstruktureinheiten, welche sich typischerweise jeweils räumlich über eine Hälfte der Primärlage erstrecken. Die beiden primären Leiterstruktureinheiten sind typischerweise jeweils sattelförmig ausgebildet und/oder zueinander symmetrisch zur Zylinderachse. Diese Ausführungsform ermöglicht eine Erzeugung eines besonders homogenen Magnetfeldgradienten.

Eine Ausführungsform der Gradientenspuleneinheit sieht vor, dass die zwei primären Leiterstruktureinheiten jeweils asymmetrisch hinsichtlich einer Ebene senkrecht zur Zylinderachse ausgebildet sind. Jede der zwei primären Leiterstruktureinheiten ist vorzugsweise asymmetrisch hinsichtlich jeder Ebene senkrecht zur Zylinderachse ausgebildet. Gemäß dieser Ausführungsform ist die Gradientenspuleneinheit vorzugsweise als lokale Gradientenspuleneinheit, insbesondere als Kopfgradientenspuleneinheit, ausgebildet. Eine lokale Gradientenspuleneinheit erfordert typischerweise einen geringeren Durchmesser und ist zur Aufnahme des Kopfes des Untersuchungsobjektes ausgebildet, insbesondere nicht zur Aufnahme des Abdomens. Die ermöglicht eine nahe Positionierung der Primärlage am Untersuchungsbereich und besonders Anstiegs- und Abfallraten von mehreren 100 kA/s. Eine Kopfgradientenspuleneinheit ist typischerweise besonders gut geeignet, wenn der Untersuchungsbereich nur den Kopf des Untersuchungsobjektes umfasst, was besonders gut anhand einer asymmetrischen lokalen Gradientenspuleneinheit realisiert werden kann. Eine lokalen Gradientenspuleneinheit, insbesondere eine Kopfgradientenspuleneinheit, ist typischerweise weniger hinsichtlich SAR und peripherer Nervenstimulation limitiert als eine Hauptgradientenspuleneinheit. Ebenso wird die Homogenität des Magnetfeldgradienten und/oder der Hauptmagnetfeldes innerhalb des Untersuchungsbereiches verbessert. Eine asymmetrische primäre Leiterstruktureinheit ermöglicht eine gute Anpassung der Gradientenspuleneinheit an die Anatomie des Untersuchungsobjektes.

Eine Ausführungsform der Gradientenspuleneinheit sieht vor, dass die Primärlage zwei Kühlkanäle und die Gradientenspule zwei Kühlkreisläufe umfasst,
wobei jeweils ein Kühlkanal einer primären Leiterstruktureinheit der zwei primären Leiterstruktureinheiten und einem Kühlkreislauf der zwei Kühlkreisläufe zugeordnet ist. Die Gradientenspule kann die zwei Kühlkreisläufe auch umfassen. Ein Kühlkreislauf umfasst typischerweise einen Kühlkanal umschließend ein Kühlmedium und eine Kühleinheit ausgebildet zur Senkung der Temperatur des Kühlmediums und/oder zur Erzeugung einer Strömung des Kühlmediums im Kühlkanal. Die zwei Kühlkreisläufe können auch eine gemeinsame Kühleinheit umfassen und/oder aus einem gleichen Reservoir eines Kühlmediums gespeist werden. Diese Ausführungsform sieht eine Kühlung der Primärlage mittels zweier Kühlkreisläufe vor. Insbesondere kann jede der zwei primären Leiterstruktureinheiten separat mittels separatem Kühlkreislauf gekühlt werden. Dies ermöglicht eine besonders effiziente und gut regulierbare Ableitung der Wärme entstehend im Betrieb der Gradientenspule und damit eine effiziente Kühlung.

Eine Ausführungsform der Gradientenspuleneinheit sieht vor, dass die Gradientenspule eine weitere Primärlage umfasst, welche hohlzylindrisch ausgebildet ist und die Primärlage radial umschließt, also insbesondere einen größeren Radius als die Primärlage aufweist. Die weitere Primärlage umfasst zwei weitere primäre Leiterstruktureinheiten und einen Kühlkanal, wobei jeweils eine weitere primäre Leiterstruktureinheit der zwei weiteren primären Leiterstruktureinheiten aus jeweils einem weiteren primären elektrischen Leiter gebildet wird, und die Primärlage und die weitere Primärlage gemeinsam zu einer Erzeugung eines Magnetfeldgradienten in die erste Raumrichtung ausgebildet sind. Die weitere Primärlage umfasst vorzugsweise zwei Kühlkanäle, wobei jeweils ein Kühlkanal der von der weiteren Primärlage umfassten zwei Kühlkanäle jeweils einer weiteren primären Leiterstruktureinheit der zwei weiteren primären Leiterstruktureinheiten zugeordnet ist. Die Primärlage und die weitere Primärlage umfassen gemeinsam vorzugsweise fünf Kühlkanäle, insbesondere fünf Kühlkreisläufe. Die Primärspule umfasst gemäß dieser Ausführungsform demnach zumindest zwei Lagen umfassend die Primärlage und die weitere Primärlage. Eine zweilagige Gradientenspule ist beispielsweise in DE102018206643A1 beschrieben. Jeder der zwei weiteren primären elektrischen Leiter ist vorzugsweise in zwei seriell miteinander verbundene Abschnitte unterteilbar und derart angeordnet, dass
- der Kühlkanal zumindest teilweise zwischen den beiden Abschnitten angeordnet ist,
- die beiden Abschnitte und der Kühlkanal zumindest teilweise parallel verlaufen, und
- die beiden Abschnitte jeweils eine Berührungsfläche mit dem Kühlkanal aufweisen.

Diese Ausführungsform ermöglicht insbesondere für eine lokale Gradientenspuleneinheit eine effiziente Erzeugung besonders starker Magnetfeldgradienten.

Eine Ausführungsform der Gradientenspuleneinheit sieht vor, dass die Gradientenspule eine Sekundärlage umfasst, welche hohlzylindrisch ausgebildet ist und die weitere Primärlage radial umschließt, also insbesondere einen größeren Radius als die weitere Primärlage und/oder die Primärlage aufweist.

Die Sekundärlage umfasst zwei sekundäre Leiterstruktureinheiten und einen Kühlkanal, wobei jeweils eine sekundäre Leiterstruktureinheit der zwei sekundären Leiterstruktureinheiten aus jeweils einem sekundären elektrischen Leiter gebildet wird, und die Sekundärlage dazu ausgebildet ist, ein bei der Erzeugung des Magnetfeldgradienten in die erste Raumrichtung entstehendes Streumagnetfeld zu kompensieren. Jeder der zwei sekundären elektrischen Leiter ist vorzugsweise in zwei seriell miteinander verbundene Abschnitte unterteilbar und derart angeordnet, dass
- der Kühlkanal zumindest teilweise zwischen den beiden Abschnitten angeordnet ist,
- die beiden Abschnitte und der Kühlkanal zumindest teilweise parallel verlaufen, und
- die beiden Abschnitte jeweils eine Berührungsfläche mit dem Kühlkanal aufweisen. Diese Ausführungsform ermöglicht eine effiziente Abschirmung der Gradientenspuleneinheit.

Eine Ausführungsform der Gradientenspuleneinheit sieht vor, dass die Gradientenspule eine Mittellage umfasst, welche hohlzylindrisch ausgebildet ist und die Primärlage radial umschließt, also insbesondere einen größeren Radius als die Primärlage und/oder die weitere Primärlage und vorzugsweise einen kleineren Radius als die Sekundärlage aufweist. Die Mittellage umfasst zwei mittlere Leiterstruktureinheiten und einen Kühlkanal, wobei jeweils eine mittlere Leiterstruktureinheit der zwei mittleren Leiterstruktureinheiten aus jeweils einem mittleren elektrischen Leiter gebildet wird, und die Mittellage zu einer Wirbelstromkompensation ausgebildet ist. Jeder der zwei mittleren elektrischen Leiter ist vorzugsweise in zwei seriell miteinander verbundene Abschnitte unterteilbar und derart angeordnet, dass
- der Kühlkanal zumindest teilweise zwischen den beiden Abschnitten angeordnet ist,
- die beiden Abschnitte und der Kühlkanal zumindest teilweise parallel verlaufen, und
- die beiden Abschnitte jeweils eine Berührungsfläche mit dem Kühlkanal aufweisen.

Die Mittellage kann zwischen der Primärlage und der weiteren Primärlage angeordnet sein. Die Mittellage kann zwischen der weiteren Primärlage und der Sekundärlage angeordnet sein. Die Mittellage ist typischerweise zwischen der Primärlage und der Sekundärlage angeordnet. Die Vorteile einer Mittellage, insbesondere für eine asymmetrische Gradientenspuleneinheit und/oder lokale Gradientenspuleneinheit ist in DE102018206643A1 offenbart. Diese Ausführungsform ermöglicht demnach eine effiziente Erzeugung hoher Magnetfeldgradienten bei zugleich guter Kompensation entstehender Wirbelströme.

Eine Ausführungsform der Gradientenspuleneinheit sieht vor, dass jeweils ein primärer elektrischer Leiter mit jeweils einem weiteren primären elektrischen Leiter und jeweils einem sekundären elektrischen Leiter elektrisch in Serie miteinander verbunden sind. Zusätzlich kann, sofern vorhanden, auch ein mittlerer elektrischer Leiter der zwei mittleren elektrischen Leiter mit jeweils einem primären elektrischen Leiter elektrisch in Serie miteinander verbunden sein. Die Ansteuerung der in Serie miteinander verbundenen elektrischen Leiter erfolgt typischerweise mittels einer Gradientenverstärkereinheit. Dies ermöglicht eine konsolidierte Ansteuerung der mehreren Leiterstruktureinheiten angeordnet in voneinander verschiedenen Lagen.

Des Weiteren geht die Erfindung aus von einem Gradientensystem umfassend eine erfindungsgemäße Gradientenspuleneinheit und zumindest zwei Gradientenverstärkereinheiten, wobei jeweils eine der zwei Gradientenverstärkereinheiten mit jeweils einem primären elektrischen Leiter in Serie verbunden ist. Eine mit einer primären Leiterstruktureinheit verbundene Gradientenverstärkereinheit ist dazu ausgebildet, in der primären Leiterstruktureinheit eine definierte elektrische Spannung und/oder einen definierten elektrischen Strom zu erzeugen, typischerweise vorgegeben durch eine Gradientensteuereinheit und/oder eine MR-Steuerungssequenz. Eine Ansteuerung der zwei Gradientenverstärkereinheiten verbunden mit zwei primären Leiterstruktureinheiten, welche einer Primärspule zuzuordnen sind, insbesondere von einer Primärspule umfasst werden, erfolgt typischerweise synchron und/oder gleichzeitig und/oder mit gleicher Amplitude. Die von diesen zwei Gradientenverstärkereinheiten erzeugten elektrischen Ströme und/oder elektrischen Spannungen unterscheiden sich typischerweise um weniger als 1%, bevorzugt um weniger als 0,5%, insbesondere zu jedem Zeitpunkt des Ausspielens einer MR-Steuerungssequenz.

Das Gradientensystem umfasst vorzugsweise sechs Gradientenverstärkereinheiten. Die Gradientenspuleneinheit umfasst vorzugsweise drei Gradientenspulen und damit drei Primärspulen. Zwei der drei Gradientenspulen unterscheiden sich lediglich durch deren Position in Umfangsrichtung, welche sich um 90° voneinander unterscheidet. Eine dritte der drei Gradientenspulen weist typischerweise zwei schraubenförmige primäre Leiterstruktureinheiten auf.

Jeweils eine primäre Leiterstruktureinheit oder schraubenförmige primäre Leiterstruktureinheit ist typischerweise durch jeweils eine der sechs Gradientenverstärkereinheiten ansteuerbar.

Ein derartiges Gradientensystems ist aufgrund der hohen Anzahl an Gradientenverstärkereinheiten und der speziellen Verschaltung dazu ausgebildet, besonders hohe elektrische Spannungen in den einzelnen primären Leiterstruktureinheiten zu erzeugen. Dies ermöglicht eine besonders hohe Amplitude der Magnetfeldgradienten, insbesondere in die erste Raumrichtung, und zugleich hohe Anstiegs- und Abfallraten trotz einer hohen Induktivität der Primärspule und/oder Primärlage.

Des Weiteren geht die Erfindung aus von einem Magnetresonanzgerät umfassend einen Hauptmagneten, eine Hochfrequenzantenneneinheit, ein erfindungsgemäßes Gradientensystem und eine mit dem Gradientensystem verbundene Gradientensteuereinheit ausgebildet zur Ansteuerung des Gradientensystems zur Erzeugung eines Magnetfeldgradienten in die erste Raumrichtung.

Die Gradientensteuereinheit ist insbesondere dazu ausgebildet, Informationen gemäß einer MR-Steuerungssequenz, insbesondere Gradientenpulse, an die vom Gradientensystem umfassten Gradientenverstärkereinheiten weiterzuleiten.

Ausführungsformen des erfindungsgemäßen Magnetresonanzgerätes und des erfindungsgemäßen Gradientensystems sind analog zu den Ausführungsformen der erfindungsgemäßen Gradientenspuleneinheit ausgebildet. Die Vorteile des erfindungsgemäßen Magnetresonanzgeräts und des erfindungsgemäßen Gradientensystems entsprechen im Wesentlichen den Vorteilen der erfindungsgemäßen Gradientenspuleneinheit, welche vorab im Detail ausgeführt sind. Hierbei erwähnte Merkmale, Vorteile oder alternative Ausführungsformen können ebenso auch auf die anderen beanspruchten Gegenstände übertragen werden und umgekehrt. Unabhängig vom grammatikalischen Geschlecht eines bestimmten Begriffes sind Personen mit männlicher, weiblicher oder anderer Geschlechteridentität mit umfasst.

Weitere Vorteile, Merkmale und Einzelheiten der Erfindung ergeben sich aus den im Folgenden beschriebenen Ausführungsbeispielen sowie anhand der Zeichnungen.

Es zeigen:
- Fig. 1: eine erste Ausführungsform einer primären Leiterstruktureinheit einer erfindungsgemäßen Gradientenspuleneinheit in einer schematischen Darstellung,
- Fig. 2: eine erste Ausführungsform einer Anordnung des Kühlkanals und eines primären elektrischen Leiters im Querschnitt in einer schematischen Darstellung,
- Fig. 3: eine zweite Ausführungsform einer Anordnung des Kühlkanals und eines primären elektrischen Leiters im Querschnitt in einer schematischen Darstellung,
- Fig. 4: eine dritte Ausführungsform einer Anordnung des Kühlkanals und eines primären elektrischen Leiters im Querschnitt in einer schematischen Darstellung,
- Fig. 5: eine zweite Ausführungsform einer primären Leiterstruktureinheit einer erfindungsgemäßen Gradientenspuleneinheit in einer vereinfachten schematischen Darstellung,
- Fig. 6: eine vierte Ausführungsform einer Anordnung des Kühlkanals und eines primären elektrischen Leiters mehrerer Windungen der primären Leiterstruktureinheit im Querschnitt in einer schematischen Darstellung,
- Fig. 7: eine erste Ausführungsform eines erfindungsgemäßen Gradientensystem in einer schematischen Darstellung,
- Fig. 8: eine zweite Ausführungsform eines erfindungsgemäßen Gradientensystem in einer schematischen Darstellung, und
- Fig. 9: ein erfindungsgemäßes Magnetresonanzgerät in einer schematischen Darstellung.

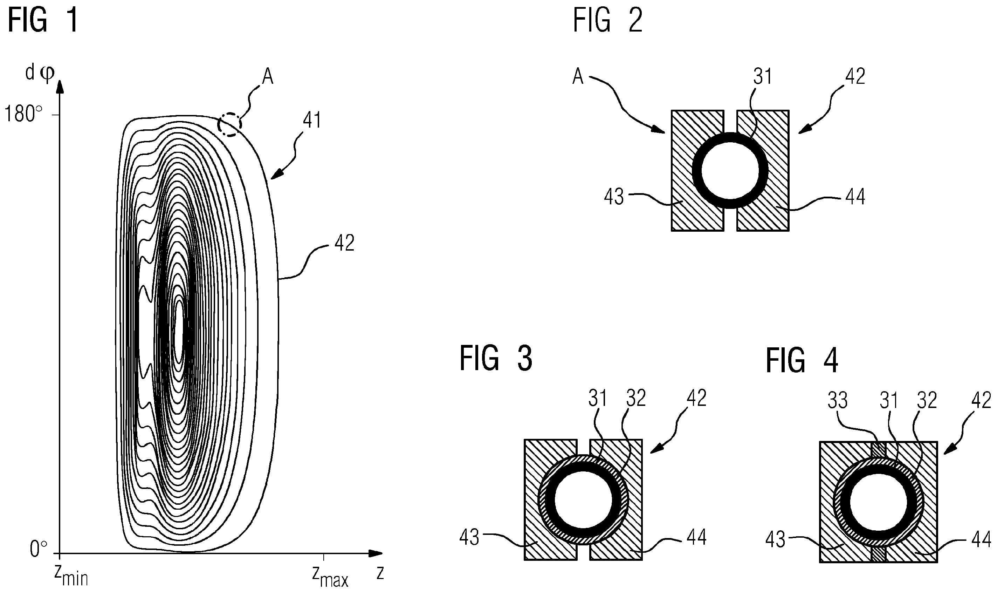

Figur 1 zeigt eine erste Ausführungsform einer primären Leiterstruktureinheit 41 einer erfindungsgemäßen Gradientenspuleneinheit 19 in einer schematischen Darstellung.

Die primäre Leiterstruktureinheit 41 ist Teil der hohlzylindrischen Primärlage 40, welche eine Zylinderachse in Längsrichtung z hohlzylindrisch umgibt, und ist in Umfangrichtung dφ in abgerollter Form dargestellt. Die primäre Leiterstruktureinheit 41 umspannt in Umfangsrichtung dφ typischerweise 180°, also eine Hälfte der Gradientenspuleneinheit 19 in Umfangsrichtung, und ist somit typischerweise sattelförmig ausgebildet. Eine zweite von der Primärlage 40 umfasste primäre Leiterstruktureinheit 41' und die primäre Leiterstruktureinheit 41 sind vorzugsweise zueinander achsensymmetrisch mit der Zylinderachse als Symmetrieachse. Die primäre Leiterstruktureinheit 41 wird aus einem primären elektrischen Leiter 42 gebildet. Die primäre Leiterstruktureinheit 41 und/oder der primäre elektrische Leiter 42 ist zumindest teilweise spiralförmig, insbesondere in Windungen umgebend zumindest einen Mittelpunkt, angeordnet. Die Primärlage 40 umfasst zudem einen nicht näher dargestellten Kühlkanal 31. Die primäre Leiterstruktureinheit 41 ist vorzugsweise asymmetrisch hinsichtlich einer Ebene senkrecht zur Zylinderachse z ausgebildet. Die primäre Leiterstruktureinheit 41 ist vorzugsweise asymmetrisch hinsichtlich jeder Ebene senkrecht zur Zylinderachse z ausgebildet.

Figur 2 zeigt eine erste Ausführungsform einer Anordnung des Kühlkanals 31 und eines primären elektrischen Leiters 42 im Querschnitt in einer schematischen Darstellung. Der Querschnitt kann beispielsweise dem Ausschnitt A in Figur 1 entsprechen. Der primäre elektrische Leiter 42 ist in zwei seriell miteinander verbundene Abschnitte 43, 44 unterteilbar. Diese Abschnitte 43, 44 sind derart angeordnet, dass die beiden Abschnitte 43, 44 und der Kühlkanal zumindest teilweise parallel verlaufen und der Kühlkanal 31 zumindest teilweise zwischen den beiden Abschnitten 43, 44 angeordnet ist, folglich die beiden Abschnitten 43, 44 den Kühlkanal 31 typischerweise zumindest teilweise umschließen. Die beiden Abschnitte 43, 44 weisen jeweils eine Berührungsfläche mit dem Kühlkanal 31 auf, insbesondere entlang dessen Längsrichtung. Die beiden Abschnitten 43, 44 liegen vorzugsweise zumindest teilweise bündig am Kühlkanal 31 an. Insbesondere ist die Querschnittsfläche der beiden Abschnitte 43, 44 vorzugsweise derart ausgestaltet, dass die beiden Abschnitte 43, 44 eine an einen Querschnitt des Kühlkanals 31 angepasste Form aufweisen. Vorzugsweise ist der Kühlkanal 31 hohlzylinderförmig ausgestaltet ist und der primäre elektrische Leiter 42 weist einen Querschnitt in Form eines Rechteckes mit einer Aussparung in Form eines Kreissegmentes auf. Der Radius des Kreissegmentes entspricht vorzugsweise dem Außenradius des Kühlkanals 31.

Figur 3 zeigt eine zweite Ausführungsform einer Anordnung des Kühlkanals und eines primären elektrischen Leiters im Querschnitt in einer schematischen Darstellung. Der Kühlkanal 31 umfasst gemäß der zweiten Ausführungsform elektrisch leitfähiges Material und der Kühlkanal 31 weist auf der dem primären elektrischen Leiter 42 und/oder den beiden Abschnitten 43, 44 zugewandten Seite eine isolierende Beschichtung 32 auf.

Figur 4 zeigt eine dritte Ausführungsform einer Anordnung des Kühlkanals und eines primären elektrischen Leiters im Querschnitt in einer schematischen Darstellung. Hierbei sind die beiden Abschnitte 43, 44 senkrecht zu einer Längsachse des Kühlkanals 31 durch den Kühlkanal 31 und/oder durch eine isolierende Schicht 33 voneinander getrennt. Insbesondere ist zwischen den beiden überwiegend parallel verlaufenden Abschnitten 43, 44 der Kühlkanal 31 angeordnet. An Positionen, an denen die räumliche Ausdehnung der beiden Abschnitte 43, 44 größer ist als die räumliche Ausdehnung des Kühlkanals 31, ist zwischen den beiden Abschnitten 43, 44 gemäß der dritten Ausführungsform eine isolierende Schicht 33, beispielsweise in Form einer Lackschicht, angeordnet. Die isolierende Beschichtung 32 und die isolierende Schicht 33 können das gleiche Material umfassen.

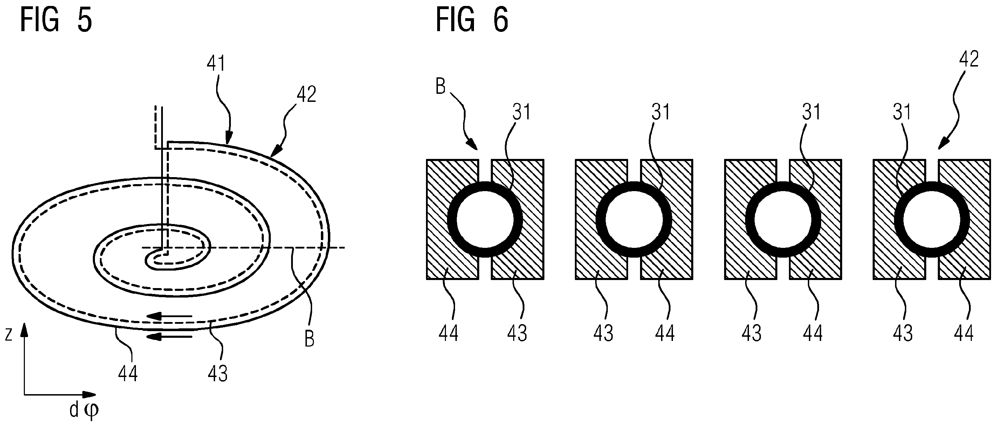

Figur 5 zeigt eine zweite Ausführungsform einer primären Leiterstruktureinheit 41 einer erfindungsgemäßen Gradientenspuleneinheit 19 in einer vereinfachten schematischen Darstellung. Insbesondere die spiralförmige Anordnung des primären elektrischen Leiters 42 ist vereinfacht mit reduzierter Anzahl an Windungen und/oder vereinfachter Form der Windungen dargestellt. Zudem wurde auf eine Darstellung des Kühlkanals 31 für eine bessere Erkennbarkeit des Verlaufs des primären elektrischen Leiters 42, insbesondere der beiden Abschnitte 43, 44, verzichtet. Figur 5 zeigt einen möglichen Verlauf des primären elektrischen Leiters 42 und dessen Unterteilung in parallel angeordnete, jedoch in Serie miteinander verbundene Abschnitte 43, 44 des primären elektrischen Leiter 42. Die auf den Abschnitten 43, 44 eingezeichneten Pfeile geben eine Richtung eines Stromflusses zur Erzeugung eines Magnetfeldgradienten in die erste Raumrichtung an. Hierbei ist erkennbar, dass in beiden benachbarten Abschnitten 43, 44 ein paralleler, insbesondere gleichgerichteter, Stromfluss erzeugt wird. Die mit B gekennzeichnete gestrichelte Linie in Figur 5 ist keine von der Leiterstruktureinheit 41 umfasste Struktur, sondern visualisiert lediglich die Position des in Figur 6 dargestellten Querschnittes.

Figur 6 zeigt eine vierte Ausführungsform einer Anordnung des Kühlkanals und eines primären elektrischen Leiters mehrerer Windungen der primären Leiterstruktureinheit im Querschnitt entlang der in Figur 5 eingezeichneten Linie B in einer schematischen Darstellung. Die beiden Abschnitte 43, 44 und der Kühlkanal 31 schneiden die Linie B mehrfach an verschiedenen Positionen in Umfangsrichtung. Die Anordnung des Kühlkanals 31 und eines primären elektrischen Leiters 42 ist derart ausgestaltet, dass der Abstand zwischen zwei benachbarten Einheiten, jeweils umfassend die beiden Abschnitte 43, 44 und den Kühlkanal 31, größer ist als der Durchmesser des Kühlkanals 31 und/oder größer ist als der Durchmesser einer Einheit. Insbesondere sind benachbarte Einheiten frei von einer Berührungsfläche. Benachbarte Einheiten sind typischerweise dadurch gekennzeichnet, dass die Zwischenräume zwischen den Windungen der benachbarten Einheiten frei von einem elektrischen Leiter sind.

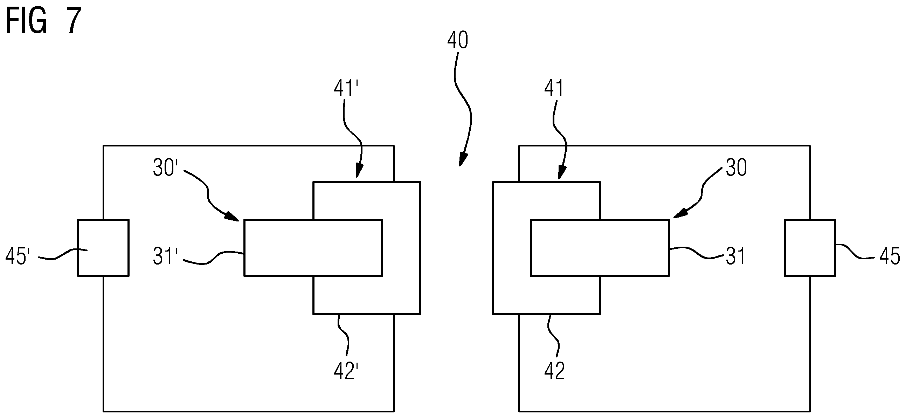

Figur 7 zeigt eine erste Ausführungsform eines erfindungsgemäßen Gradientensystems in einer schematischen Darstellung. Das Gradientensystem umfasst eine erfindungsgemäße Gradientenspuleneinheit 19 mit einer hohlzylindrischen Primärlage 40 umfassend zwei primäre Leiterstruktureinheiten 41, 41' gebildet aus jeweils einem primären elektrischen Leiter 42, 42'. Das Gradientensystem, insbesondere die Primärlage 40, gemäß der in Figur 7 dargestellten ersten Ausführungsform umfasst zudem zwei Kühlkanäle 31, 31', wobei jeweils ein Kühlkanal der zwei Kühlkanäle 31, 31' einer primären Leiterstruktureinheit der zwei primären Leiterstruktureinheiten 41, 41' zugeordnet ist. Des Weiteren umfasst das Gradientensystem gemäß der ersten Ausführungsform zwei Gradientenverstärkereinheiten 45, 45', wobei jeweils eine der zwei Gradientenverstärkereinheiten mit jeweils einem primären elektrischen Leiter 42, 42' in Serie verbunden ist. Die Gradientenspule umfasst zwei Kühlkreisläufe 30, 30', wobei jeweils ein Kühlkanal der zwei Kühlkanäle 31, 31' einem Kühlkreislauf der zwei Kühlkreisläufe 30, 30' zugeordnet ist.

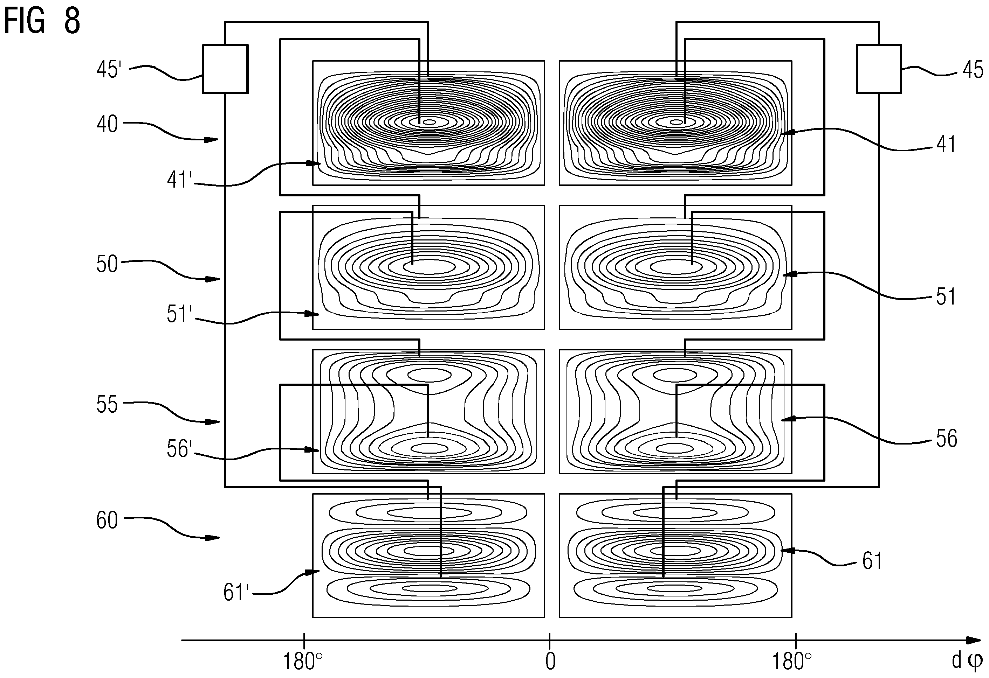

Figur 8 zeigt eine zweite Ausführungsform eines erfindungsgemäßen Gradientensystem in einer schematischen Darstellung. Diese zweite Ausführungsform des Gradientensystems unterscheidet sich von der ersten Ausführung insbesondere durch die Gradientenspule, welche neben der Primärlage 40 weitere Lagen umfasst. Insbesondere umfasst die Gradientenspule eine weitere Primärlage 50, welche hohlzylindrisch ausgebildet ist und die Primärlage 40 radial umschließt. Die weitere Primärlage 50 umfasst zwei weitere primäre Leiterstruktureinheiten 51, 51' und einen nicht näher dargestellten Kühlkanal, wobei jeweils eine weitere primäre Leiterstruktureinheit der zwei weiteren primären Leiterstruktureinheiten 51, 51' aus jeweils einem weiteren primären elektrischen Leiter gebildet wird, und die Primärlage 40 und die weitere Primärlage 50 gemeinsam zu einer Erzeugung eines Magnetfeldgradienten in die erste Raumrichtung ausgebildet sind.

Zudem umfasst die Gradientenspule eine Mittellage 55, welche hohlzylindrisch ausgebildet ist und die weitere Primärlage 50 radial umschließt. Die Mittellage 55 umfasst zwei mittlere Leiterstruktureinheiten 56, 56' und einen nicht näher dargestellten Kühlkanal, wobei jeweils eine mittlere Leiterstruktureinheit der zwei mittleren Leiterstruktureinheiten 56, 56' aus jeweils einem mittleren elektrischen Leiter gebildet wird.

Zudem umfasst die Gradientenspule eine Sekundärlage 60, welche hohlzylindrisch ausgebildet ist und die weitere Primärlage 50 und auch die Mittellage 55 radial umschließt. Die Sekundärlage 60 umfasst zwei sekundäre Leiterstruktureinheiten 61, 61' und einen nicht näher dargestellten Kühlkanal, wobei jeweils eine sekundäre Leiterstruktureinheit der zwei sekundären Leiterstruktureinheiten 61, 61' aus einem sekundären elektrischen Leiter gebildet wird. Die Sekundärlage 60 ist zu einer Abschirmung des Magnetfeldgradienten in den Außenbereich der Gradientenspuleneinheit 19 ausgebildet.

Jeweils eine der zwei Gradientenverstärkereinheiten 45, 45' ist mit jeweils einem primären elektrischen Leiter 42, 42', jeweils einem weiteren primären elektrischen Leiter, jeweils einem sekundären elektrischen Leiter und jeweils einem mittleren elektrischen Leiter in Serie verbunden.

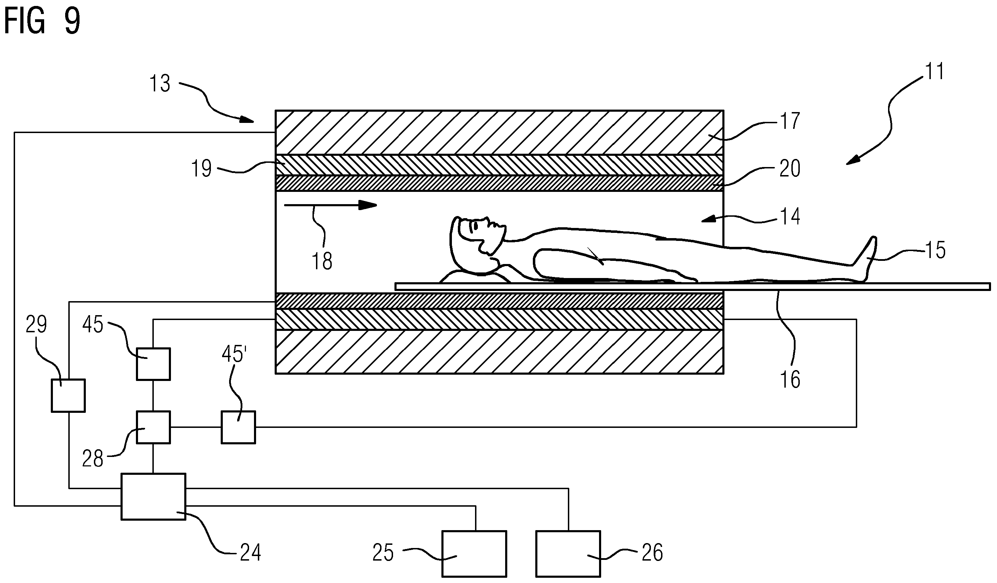

Figur 9 zeigt ein erfindungsgemäßes Magnetresonanzgerät 11 in einer schematischen Darstellung. Das Magnetresonanzgerät 11 umfasst eine Detektoreinheit 13 mit einem Hauptmagneten 17 zu einem Erzeugen eines starken und insbesondere konstanten Hauptmagnetfelds 18 parallel zur Längsrichtung, insbesondere parallel zur Zylinderachse. Zudem weist das Magnetresonanzgerät 11 einen zylinderförmigen Patientenaufnahmebereich 14 zu einer Aufnahme eines Patienten 15 auf, wobei der Patientenaufnahmebereich 14 in einer Umfangsrichtung von der Detektoreinheit 13 zylinderförmig umschlossen ist. Der Patient 15 kann mittels einer Patientenlagerungsvorrichtung 16 des Magnetresonanzgeräts 11 in den Patientenaufnahmebereich 14 geschoben werden. Die Patientenlagerungsvorrichtung 16 weist hierzu einen Patiententisch auf, der bewegbar innerhalb des Magnetresonanzgeräts 11 angeordnet ist. Die Detektoreinheit 13 weist weiterhin eine Hochfrequenzantenneneinheit 20, welche im gezeigten Fall als fest in das Magnetresonanzgerät 11 integrierte Körperspule ausgebildet ist, und eine Hochfrequenzantennensteuereinheit 29 zu einer Anregung einer Polarisation, die sich in dem von dem Hauptmagneten 17 erzeugten Hauptmagnetfeld 18 einstellt, auf. Die Hochfrequenzantenneneinheit 20 wird von der Hochfrequenzantennensteuereinheit 29 angesteuert und strahlt hochfrequente Hochfrequenz-Pulse in einen Untersuchungsraum, der im Wesentlichen von dem Patientenaufnahmebereich 14 gebildet ist, ein.

Des Weiteren weist die Detektoreinheit 13 eine erfindungsgemäße Gradientenspuleneinheit 19 auf, die für eine Ortskodierung während einer Bildgebung verwendet werden. Die Gradientenspuleneinheit 19 umfasst eine hohlzylindrische Primärlage 40 als Teil einer Gradientenspule umgebend den zylinderförmigen Patientenaufnahmebereich 14 in Längsrichtung, welche Gradientenspule zur Erzeugung eines Magnetfeldgradienten in eine erste Raumrichtung ausgebildet ist. Die Primärlage 40 umfasst zwei primäre Leiterstruktureinheiten 41, 41', wobei jeweils eine primäre Leiterstruktureinheit der zwei primären Leiterstruktureinheiten aus jeweils einem primären elektrischen Leiter 42, 42' gebildet wird. Das Magnetresonanzgerät 11 umfasst zudem zwei Gradientenverstärkereinheiten 45, 45', wobei jeweils eine der zwei Gradientenverstärkereinheiten 45, 45' mit jeweils einem primären elektrischen Leiter 42, 42' in Serie verbunden ist.

Die Gradientenspuleneinheit 19, insbesondere die zwei Gradientenverstärkereinheiten 45, 45', werden mittels einer Gradientensteuereinheit 28 zur Erzeugung eines Magnetfeldgradienten in die erste Raumrichtung angesteuert. Die Gradientensteuereinheit 28 ist typischerweise zur Ansteuerung aller vom Gradientensystem umfassten Gradientenverstärkereinheiten 45, 45' ausgebildet. Hierzu ist die Gradientensteuereinheit 28 typischerweise mit den Gradientenverstärkereinheiten 45, 45' verbunden, und diese sind dazu ausgebildet, eine elektrische Spannung und/oder einen elektrischen Strom, insbesondere Gradientenpulse gemäß einer MR-Steuerungssequenz, wie beispielsweise durch die Gradientensteuereinheit 28 vorgegeben, in der Gradientenspuleneinheit 19 zu erzeugen. Für eine detaillierte Darstellung der Gradientenspuleneinheit 19 und/oder der Primärlage 40 sei insbesondere auf die Figuren 1 bis 8 verwiesen.

Zu einer Steuerung des Hauptmagneten 17, der Gradientensteuereinheit 28 und der Hochfrequenzantennensteuereinheit 29 weist das Magnetresonanzgerät 11 eine Steuerungseinheit 24 auf. Die Steuerungseinheit 24 steuert zentral das Magnetresonanzgerät 11, wie beispielsweise das Durchführen von MR-Steuerungssequenzen. Das Magnetresonanzgerät 11 weist eine Anzeigeeinheit 25 auf. Zudem weist das Magnetresonanzgerät 11 eine Eingabeeinheit 26 auf, mittels derer Informationen und/oder Steuerungsparameter während eines Messvorgangs von einem Benutzer eingegeben werden können. Die Steuerungseinheit 24 kann die Gradientensteuereinheit 28 und/oder Hochfrequenzantennensteuereinheit 29 und/oder die Anzeigeeinheit 25 und/oder die Eingabeeinheit 26 umfassen.

Das dargestellte Magnetresonanzgerät 11 kann selbstverständlich weitere Komponenten umfassen, die Magnetresonanzgeräte 11 gewöhnlich aufweisen. Eine allgemeine Funktionsweise eines Magnetresonanzgeräts 11 ist zudem dem Fachmann bekannt, so dass auf eine detaillierte Beschreibung der weiteren Komponenten verzichtet wird.

Obwohl die Erfindung im Detail durch die bevorzugten Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen, der durch die Ansprüche definiert wird.

## Patentansprüche

1. Gradientenspuleneinheit (19) für ein Magnetresonanzgerät (11) umfassend eine Gradientenspule umgebend eine Zylinderachse und ausgebildet zur Erzeugung eines Magnetfeldgradienten in eine erste Raumrichtung, welche Gradientenspule eine hohlzylindrische Primärlage (40) umfassend zwei primäre Leiterstruktureinheiten (41, 41') und einen Kühlkanal (31, 31') umfasst,
wobei jeweils eine primäre Leiterstruktureinheit (41, 41') der zwei primären Leiterstruktureinheiten (41, 41') aus jeweils einem primären elektrischen Leiter (42, 42') gebildet wird, welcher primäre elektrische Leiter (42, 42') aus zwei elektrisch seriell miteinander verbundenen Abschnitten (43, 44) besteht, wobei sich die Länge der beiden Abschnitte (43, 44) um weniger als 5% unterscheidet, **dadurch gekennzeichnet, dass** der primäre elektrische Leiter (42, 42') derart spiralförmig in Windungen angeordnet ist, dass
- zwei benachbarte Windungen des primären elektrischen Leiters (42, 42') den beiden voneinander verschiedenen Abschnitten (43, 44) zuzuordnen sind, wobei eine Windung einem jeweiligen Abschnitt zuzuordnen ist, wenn die Windung aus dem jeweiligen Abschnitt des primären elektrischen Leiters geformt wird,
- der Kühlkanal (31, 31') zumindest teilweise zwischen den beiden Abschnitten (43, 44) angeordnet ist,
- die beiden Abschnitte (43, 44) und der Kühlkanal (31, 31') zumindest teilweise parallel verlaufen, und
- die beiden Abschnitte (43, 44) jeweils eine Berührungsfläche mit dem Kühlkanal (31, 31') aufweisen.

2. Gradientenspuleneinheit (19) nach Anspruch 1,
wobei der primäre elektrische Leiter (42, 42') derart angeordnet ist, dass bei Ansteuerung der Gradientenspule in beiden Abschnitten (43, 44) ein paralleler, insbesondere gleichgerichteter, Stromfluss erzeugt wird.

3. Gradientenspuleneinheit (19) nach einem der vorangehenden Ansprüche, wobei der Kühlkanal (31, 31') elektrisch leitfähiges Material umfasst und der Kühlkanal (31, 31') auf der dem primären elektrischen Leiter (42, 42') und/oder den beiden Abschnitten (43, 44) zugewandten Seite eine isolierende Beschichtung (32) aufweist.

4. Gradientenspuleneinheit (19) nach einem der vorangehenden Ansprüche, wobei die beiden Abschnitte (43, 44) senkrecht zu einer Längsachse des Kühlkanals durch den Kühlkanal (31, 31') und/oder durch eine isolierende Schicht (33) voneinander getrennt sind.

5. Gradientenspuleneinheit (19) nach einem der vorangehenden Ansprüche, wobei die beiden Abschnitte (43, 44) den Kühlkanal (31, 31') zumindest teilweise umschließen und/oder zumindest teilweise bündig am Kühlkanal (31, 31') anliegen.

6. Gradientenspuleneinheit (19) nach einem der vorangehenden Ansprüche, wobei der Kühlkanal (31, 31') hohlzylinderförmig ausgestaltet ist und/oder der primäre elektrische Leiter (42, 42') einen Querschnitt in Form eines Rechteckes mit einer Aussparung in Form eines Kreissegmentes aufweist.

7. Gradientenspuleneinheit (19) nach einem der vorangehenden Ansprüche, wobei die zwei primären Leiterstruktureinheiten (41, 41') zueinander achsensymmetrisch, insbesondere mit der Zylinderachse als Symmetrieachse, ausgebildet sind.

8. Gradientenspuleneinheit (19) nach einem der vorangehenden Ansprüche, wobei die zwei primären Leiterstruktureinheiten (41, 41') jeweils asymmetrisch hinsichtlich einer Ebene senkrecht zur Zylinderachse ausgebildet sind.

9. Gradientenspuleneinheit (19) nach einem der vorangehenden Ansprüche, wobei die Primärlage (40) zwei Kühlkanäle (31, 31') und die Gradientenspule zwei Kühlkreisläufe (30, 30') umfasst,
wobei jeweils ein Kühlkanal (31, 31') einer primären Leiterstruktureinheit (41, 41') der zwei primären Leiterstruktureinheiten (41, 41') und einem Kühlkreislauf (30, 30') der zwei Kühlkreisläufe (30, 30') zugeordnet ist.

10. Gradientenspuleneinheit (19) nach einem der vorangehenden Ansprüche, wobei die Gradientenspule eine weitere Primärlage (50) umfasst, welche hohlzylindrisch ausgebildet ist und die Primärlage (40) radial umschließt,
die weitere Primärlage (50) zwei weitere primäre Leiterstruktureinheiten (51, 51') und einen Kühlkanal umfasst, wobei jeweils eine weitere primäre Leiterstruktureinheit (51, 51') der zwei weiteren primären Leiterstruktureinheiten (51, 51') aus jeweils einem weiteren primären elektrischen Leiter gebildet wird,
und die Primärlage (40) und die weitere Primärlage (50) gemeinsam zu einer Erzeugung eines Magnetfeldgradienten in die erste Raumrichtung ausgebildet sind.

11. Gradientenspuleneinheit (19) nach einem der vorangehenden Ansprüche, wobei die Gradientenspule eine Sekundärlage (60) umfasst, welche hohlzylindrisch ausgebildet ist und die weitere Primärlage (50) radial umschließt,
die Sekundärlage (60) zwei sekundäre Leiterstruktureinheiten (61, 61') und einen Kühlkanal umfasst, wobei jeweils eine sekundäre Leiterstruktureinheit (61, 61') der zwei sekundären Leiterstruktureinheiten (61, 61') aus jeweils einem sekundären elektrischen Leiter gebildet wird,
und die Sekundärlage (60) dazu ausgebildet ist, ein bei der Erzeugung des Magnetfeldgradienten in die erste Raumrichtung entstehendes Streumagnetfeld zu kompensieren.

12. Gradientenspuleneinheit (19) nach einem der vorangehenden Ansprüche, wobei die Gradientenspule eine Mittellage (55) umfasst, welche hohlzylindrisch ausgebildet ist und die weitere Primärlage (50) radial umschließt,
die Mittellage (55) zwei mittlere Leiterstruktureinheiten (56, 56') und einen Kühlkanal umfasst, wobei jeweils eine mittlere Leiterstruktureinheit (56, 56') der zwei mittleren Leiterstruktureinheiten (56, 56') aus jeweils einem mittleren elektrischen Leiter gebildet wird,
und die Mittellage (55) zu einer Wirbelstromkompensation ausgebildet ist.

13. Gradientenspuleneinheit (19) nach den Ansprüchen 10 und 11, wobei jeweils ein primärer elektrischer Leiter (42, 42') mit jeweils einem weiteren primären elektrischen Leiter und jeweils einem sekundären elektrischen Leiter elektrisch in Serie miteinander verbunden sind.

14. Gradientensystem umfassend eine Gradientenspuleneinheit (19) nach einem der vorangehenden Ansprüche und zumindest zwei Gradientenverstärkereinheiten (45, 45'), wobei jeweils eine der zwei Gradientenverstärkereinheiten (45, 45') mit jeweils einem primären elektrischen Leiter (42, 42') in Serie verbunden ist.

15. Magnetresonanzgerät (11) umfassend einen Hauptmagneten (17), eine Hochfrequenzantenneneinheit (20), ein Gradientensystem nach Anspruch 14 und eine mit dem Gradientensystem verbundene Gradientensteuereinheit (28) ausgebildet zur Ansteuerung des Gradientensystems zur Erzeugung eines Magnetfeldgradienten in die erste Raumrichtung.

## Claims

1. Gradient coil unit (19) for a magnetic resonance device (11) comprising a gradient coil surrounding a cylinder axis and embodied to generate a magnetic field gradient in a first spatial direction, which gradient coil comprises a hollow cylindrical primary layer (40) comprising two primary conductor structural units (41, 41') and a cooling duct (31, 31'),
wherein one primary conductor structural unit (41, 41') respectively of the two primary conductor structural units (41, 41') is formed from one primary electrical conductor (42, 42') respectively, which primary electrical conductor (42, 42') consists of two sections (43, 44) electrically connected to one another in series, wherein the length of the two sections (43, 44) differs by less than 5%, **characterised in that** the primary electrical conductor (42, 42') is helically arranged in windings in such a way that
- two adjacent windings of the primary electrical conductor (42, 42') are to be associated with the two mutually different sections (43, 44), wherein a winding is to be associated with a respective section if the winding is formed from the respective section of the primary electrical conductor,
- the cooling duct (31, 31') is arranged at least partially between the two sections (43, 44),
- the two sections (43, 44) and the cooling duct (31, 31') run at least partially parallel, and
- the two sections (43, 44) have one contact surface respectively with the cooling duct (31, 31').

2. Gradient coil unit (19) according to claim 1,
wherein the primary electrical conductor (42, 42') is arranged in such a way that when the gradient coil is actuated, a parallel, in particular rectified, flow of current is generated in the two sections (43, 44).

3. Gradient coil unit (19) according to one of the preceding claims, wherein the cooling duct (31, 31') comprises electrically conductive material and, on the side facing the primary electrical conductor (42, 42') and/or the two sections (43, 44), the cooling duct (31, 31') has an insulating coating (32).

4. Gradient coil unit (19) according to one of the preceding claims, wherein the two sections (43, 44) are separated from one another perpendicular to a longitudinal axis of the cooling duct by the cooling duct (31, 31') and/or by an insulating layer (33).

5. Gradient coil unit (19) according to one of the preceding claims, wherein the two sections (43, 44) at least partially surround the cooling duct (31, 31') and/or at least partially flush with the cooling duct (31, 31').

6. Gradient coil unit (19) according to one of the preceding claims, wherein the cooling duct (31, 31') is embodied in the shape of a hollow cylinder and/or the primary electrical conductor (42, 42') has a cross-section in the shape of a rectangle with a recess in the shape of a segment of a circle.

7. Gradient coil unit (19) according to one of the preceding claims, wherein the two primary conductor structural units (41, 41') are embodied to be axially symmetrical to one another, in particular with the cylinder axis as an axis of symmetry.

8. Gradient coil unit (19) according to one of the preceding claims, wherein the two primary conductor structural units (41, 41') respectively are asymmetrically embodied with regard to a plane perpendicular to the cylinder axis.

9. Gradient coil unit (19) according to one of the preceding claims, wherein the primary layer (40) comprises two cooling ducts (31, 31') and the gradient coil two cooling circuits (30, 30'),
wherein one cooling duct (31, 31') respectively is associated with one primary conductor structural unit (41, 41') of the two primary conductor structural units (41, 41') and one cooling circuit (30, 30') of the two cooling circuits (30, 30').

10. Gradient coil unit (19) according to one of the preceding claims, wherein the gradient coil comprises a further primary layer (50), which is embodied in the shape of a hollow cylinder and radially surrounds the primary layer (40),
the further primary layer (50) comprises two further primary conductor structural units (51, 51') and a cooling duct, wherein one further primary conductor structural unit (51, 51') respectively of the two further primary conductor structural units (51, 51') is formed from one further primary electrical conductor respectively,
and the primary layer (40) and the further primary layer (50) are jointly embodied to generate a magnetic field gradient in the first spatial direction.

11. Gradient coil unit (19) according to one of the preceding claims, wherein the gradient coil comprises a secondary layer (60), which is embodied in the shape of a hollow cylinder and radially surrounds the further primary layer (50),
the secondary layer (60) comprises two secondary conductor structural units (61, 61') and a cooling duct, wherein one secondary conductor structural unit (61, 61') respectively of the two secondary conductor structural units (61, 61') is formed from one secondary electrical conductor respectively, and the secondary layer (60) embodied to compensate a stray magnetic field developing in the first spatial direction during the generation of the magnetic field gradient.

12. Gradient coil unit (19) according to one of the preceding claims, wherein the gradient coil comprises a middle layer (55), which is embodied in the shape of a hollow cylinder and radially surrounds the further primary layer (50),
the middle layer (55) comprises two middle conductor structural units (56, 56') and a cooling duct, wherein one middle conductor structural unit (56, 56') respectively of the two middle conductor structural units (56, 56') is formed from one middle electrical conductor respectively,
and the middle layer (55) is embodied to compensate eddy currents.

13. Gradient coil unit (19) according to claims 10 and 11, wherein one primary electrical conductor (42, 42') respectively with one further primary electrical conductor respectively and one secondary electrical conductor respectively are electrically connected to one another in series.

14. Gradient system comprising a gradient coil unit (19) according to one of the preceding claims and at least two gradient amplifier units (45, 45'), wherein one of the two gradient amplifier units (45, 45') respectively is connected in series to one primary electrical conductor (42, 42') respectively.

15. Magnetic resonance device (11) comprising a main magnet (17), a radio-frequency antenna unit (20), a gradient system according to claim 14 and a gradient control unit (28), connected to the gradient system, embodied to actuate the gradient system for generating a magnetic field gradient in the first spatial direction.

## Revendications

1. Unité (19) de bobine à gradient pour un appareil (11) de résonnance magnétique comprenant une bobine à gradient entourant un axe de cylindre et constituée pour la production de gradients de champ magnétique dans une première direction de l'espace, laquelle bobine à gradient comprend une couche (40) primaire cylindrique creuse comprenant deux unités (41, 41') primaires de structure conductrice et un conduit (31, 31') de refroidissement, dans laquelle respectivement une unité (41, 41') primaire de structure conductrice des deux unités (41, 41') primaires de structure conductrice est formée respectivement d'un conducteur (42, 42') électrique primaire, lequel conducteur (42, 42') électrique primaire est constitué de deux parties (43, 44) montées ensemble électriquement en série, dans laquelle la longueur des deux parties (43, 44) est différente de moins de 5 %, **caractérisée en ce que** le conducteur (42, 42') électrique primaire est disposé en spires en forme de spirale, de manière à ce que
- deux spires voisines du conducteur (42, 42') électrique primaire soient affectées aux deux parties (43, 44) différentes l'une de l'autre, dans laquelle une spire est affectée à une partie respective, lorsque la spire est formée de la partie respective du conducteur électrique primaire,
- le conduit (31, 31') de refroidissement est disposé au moins partiellement entre les deux parties (43, 44),
- les deux parties (43, 44) et le conduit (31, 31') de refroidissement s'étendent en parallèle au moins en partie, et
- les deux parties (43, 44) ont respectivement une surface de contact avec le conduit (31, 31') de refroidissement.

2. Unité (19) de bobine à gradient suivant la revendication 1, dans laquelle le conducteur (42, 42') électrique primaire est disposé de manière à produire, lors de la commande de la bobine à gradient, un flux de courant parallèle, en particulier de même sens, dans les deux parties (43, 44).

3. Unité (19) de bobine à gradient suivant l'une des revendications précédentes, dans laquelle le conduit (31, 31') de refroidissement comprend du matériau conducteur de l'électricité et le conduit (31, 31') de refroidissement a un revêtement (32) isolant du côté tourné vers le conducteur (42, 42') électrique primaire et/ou les deux parties (43, 44).

4. Unité (19) de bobine à gradient suivant l'une des revendications précédentes, dans laquelle les deux parties (43, 44) sont, perpendiculairement à un axe longitudinal du conduit de refroidissement, séparées l'une de l'autre par le conduit (31, 31') de refroidissement et/ou par une couche (33) isolante.

5. Unité (19) de bobine à gradient suivant l'une des revendications précédentes, dans laquelle les deux parties (43, 44) entourent au moins en partie le conduit (31, 31') de refroidissement et/ou s'appliquent au moins en partie à affleurement au moins partiellement au conduit (31, 31') de refroidissement.

6. Unité (19) de bobine à gradient suivant l'une des revendications précédentes, dans laquelle le conduit (31, 31') de refroidissement est conformé en forme de cylindre creux et/ou le conducteur (42, 42') électrique primaire a une section transversale sous la forme d'un rectangle ayant un évidement sous la forme d'un segment de cercle.

7. Unité (19) de bobine à gradient suivant l'une des revendications précédentes, dans laquelle les deux unités (41, 41') primaires de structure conductrice sont constituées en étant symétriques l'une de l'autre par rapport à un axe, en particulier en ayant l'axe du cylindre comme axe de symétrie.

8. Unité (19) de bobine à gradient suivant l'une des revendications précédentes, dans laquelle les deux unités (41, 41') primaires de structure conductrice sont constituées en étant respectivement dissymétriques par rapport à un plan perpendiculaire à l'axe du cylindre.

9. Unité (19) de bobine à gradient suivant l'une des revendications précédentes, dans laquelle la couche (40) primaire comprend deux conduits (31, 31') de refroidissement et la bobine à gradient comprend deux circuits (30, 30') de refroidissement, dans laquelle respectivement un conduit (31, 31') de refroidissement est affecté à une unité (41, 41') primaire de structure conductrice des deux unités (41, 41') primaires de structure conductrice et à un circuit (30, 30') de refroidissement des deux circuits (30, 30') de refroidissement.

10. Unité (19) de bobine à gradient suivant l'une des revendications précédentes, dans laquelle la bobine à gradient comprend une autre couche (50) primaire, qui est constituée sous la forme d'un cylindre creux et qui entoure radialement la couche (40) primaire,
l'autre couche (50) primaire comprend deux autres unités (51, 51') primaires de structure conductrice et un conduit de refroidissement, dans laquelle respectivement une autre unité (51, 51') primaire de structure conductrice des autres deux unités (51, 51') primaires de structure conductrice est formée de respectivement un autre conducteur électrique primaire,
et la couche (40) primaire et l'autre couche (50) primaire sont formées conjointement pour une production d'un gradient de champ magnétique dans la première direction de l'espace.

11. Unité (19) de bobine à gradient suivant l'une des revendications précédentes, dans laquelle la bobine à gradient comprend une couche (60) secondaire, qui est constituée sous la forme d'un cylindre creux et qui entoure radialement l'autre couche (50) primaire,
la couche (60) secondaire comprend deux unités (61, 61') secondaires de structure conductrice et un conduit de refroidissement, dans laquelle respectivement une unité (61, 61') secondaire de structure conductrice des deux unités (61, 61') secondaires de structure conductrice est formée respectivement d'un conducteur électrique secondaire,
et la couche (60) secondaire est constituée pour compenser un champ magnétique de dispersion se créant dans la première direction de l'espace, lors de la production du gradient de champ magnétique.

12. Unité (19) de bobine à gradient suivant l'une des revendications précédentes, dans laquelle la bobine à gradient comprend une couche (55) médiane, qui est constituée sous la forme d'un cylindre creux et qui entoure radialement l'autre couche (50) primaire,
la couche (55) médiane comprend deux unités (56, 56') médianes de structure conductrice et un conduit de refroidissement, dans laquelle respectivement une unité (56, 56') médiane de structure conductrice des deux unités (56, 56') médianes de structure conductrice est formée respectivement d'un conducteur électrique médian,
et la couche (55) médiane est constituée pour une compensation des courants de Foucault.

13. Unité (19) de bobine à gradient suivant les revendications 10 et 11, dans laquelle respectivement un conducteur (42, 42') électrique primaire est monté électriquement en série avec respectivement un autre conducteur électrique primaire et respectivement un conducteur électrique secondaire.

14. Système à gradient comprenant une unité (19) de bobine à gradient suivant l'une des revendications précédentes et au moins deux unités (45, 45') renforçant le gradient, dans lequel respectivement l'une des deux unités (45, 45') renforçant le gradient est montée en série avec respectivement un conducteur (42, 42') électrique primaire.

15. Appareil (11) de résonnance magnétique comprenant un aimant (17) principal, une unité (20) d'antenne de haute fréquence et un système à gradient suivant la revendication 14 et une unité (28) de commande de gradient reliée au système à gradient et constituée pour la commande du système de gradient, afin de produire un gradient de champ magnétique dans la première direction de l'espace.
